# EUROPÄISCHE PATENTSCHRIFT

(11) **EP 0 729 583 B1**
(45) Veröffentlichungstag und Bekanntmachung des Hinweises auf die Patenterteilung: **06.05.1998**
(21) Anmeldenummer: 95900073.8
(22) Anmeldetag: 09.11.1994
(51) Int. Cl.: G01R 25/08

(54) **PHASENMESSVORRICHTUNG**
PHASE-MEASUREMENT DEVICE
DISPOSITIF DE MESURE DE PHASE

(30) Priorität: 18.11.1993 DE 4339303
(43) Veröffentlichungstag der Anmeldung: 04.09.1996
(73) Patentinhaber: ROBERT BOSCH GMBH, 70442 Stuttgart (DE)
(72) Erfinder: STEINLECHNER, Siegbert, D-71229 Leonberg (DE)
(86) Internationale Anmeldenummer: DE9401325
(87) Internationale Veröffentlichungsnummer: WO9514236

(56) Entgegenhaltungen:
- FR-A- 2 484 104
- US-A- 4 902 920
- PATENT ABSTRACTS OF JAPAN vol. 7, no. 82 (P-189) (1227) 6. April 1983 & JP,A,58 010 665 (TOKYO SHIBAURA DENKI KK) 21. Januar 1983
- PATENT ABSTRACTS OF JAPAN vol. 16, no. 89 (P-1320) 4. März 1992 & JP,A,03 272 404 (NIKON CORP.) 4. Dezember 1991

## Beschreibung

### Stand der Technik

Die Erfindung geht aus von einer Vorrichtung zum Ermitteln der Phasendifferenz zwischen zwei digitalen Eingangssignalen nach der Gattung des unabhängigen Anspruchs. Aus dem Fachbuch von U. Tietze und Ch. Schenk, "Halbleiter-Schaltungstechnik", Springer-Verlag, 1989, Abschnitte 27.4.1 - 27.4.4, Seiten 956 - 967 sind Phasenmeßvorrichtungen bekannt. Bei den in den Abschnitten 27.4.1 und 27.4.2 beschriebenen Abtast-Haltegliedern und den Synchrongleichrichtern, die jeweils als Phasenmeßvorrichtungen eingesetzt sind, ist der Zusammenhang zwischen einer Phasenverschiebung und dem Ausgangssignal nicht linear. Die in den Abschnitten 27.4.3 und 27.4.4 enthaltenen Schaltungsvorschläge erzeugen aus analogen Eingangssignalen ein Digitalsignal mit bekannter Amplitude, das mit einem analogen Tiefpaß gefiltert wird. Die am Ausgang des Tiefpasses abgreifbare Spannung ist ein Maß für die Phasenverschiebung. Die im Kapitel 27.4.4 beschriebene Schaltung ermöglicht die Ermittlung einer Phasendifferenz, die Werte von 360° übersteigt. Die Phaseninformation ist auch bei dieser Schaltung im Mittelwert eines digitalen Signals enthalten und wird mit einer analogen Tiefpaßfilterung bereitgestellt.

Aus der US-A 4,902,920 ist eine Phasenmeßvorrichtung zur Ermittlung der Phasendifferenz zwischen zwei digitalen Eingangssignalen bekannt. Der grobe Phasenwert, der Vielfachen von 360° entspricht, wird asynchron digital gemessen, während der Feinwert, der einem Phasenwert von 0° bis 360° entspricht, analog gemessen, anschließend zeitlich gemittelt und danach von einem Analog/Digital-Wandler in einen digitalen Wert umgesetzt wird. Bedingt durch dieses Arbeitsprinzip können der Grob- und Feinmeßwert keinen zeitlichen Bezug zueinander aufweisen. Die vorbekannte Phasenmeßeinrichtung kann daher schnelle Phasenänderungen wegen der zeitlichen Mittelwertbildung nicht verarbeiten.

Weiterhin ist aus der FR-A 2 484 104 eine Phasenmeßvorrichtung bekannt, welche die Ermittlung einer Phasendifferenz zwischen 0° und 360° ermöglicht. Die vorbekannte Phasenmeßeinrichtung benötigt eine Taktfrequenz, die unabhängig ist von beiden Eingangssignalen. Sämtliche den einzelnen Komparatoren zugeführten Signale werden von Frequenzteilern bereitgestellt. Mit diesen Maßnahmen können lediglich mittlere Werte der Phasenverschiebungen zwischen einzelnen Eingangssignalen ermittelt werden.

Der Erfindung liegt die Aufgabe zugrunde, eine Phasenmeßvorrichtung anzugeben, die eine hohe Meßrate ermöglicht.

Die Aufgabe wird durch die im unabhängigen Anspruch angegebenen Merkmale gelöst.

### Vorteile der Erfindung

Die erfindungsgemäße Phasenmeßvorrichtung weist den Vorteil auf, daß unmittelbar nach Abschluß einer Periode des zweiten Eingangssignals ein aktueller Meßwert in der Phasendifferenz zur Verfügung steht. Die beiden Eingangssignale steuern jeweils derart einen Zähler mit jeweils vorgegebenen Flanken, daß die Zählerstände ein Maß für die Phasendifferenz ist. Der Zählerstand des ersten Zählers ist hierbei ein Maß für die Phasendifferenz im Bereich von 0° bis 360° und der Zählerstand des zweiten Zählers, der als Vorwärts/Rückwärts-Zähler ausgebildet ist, wird als Maß für Vielfache von 360° Phasendifferenz gewertet. Durch die Realisierung des zweiten Zählers als Vorwärts/Rückwärts-Zähler kann die Frequenz des zweiten Eingangssignals gegenüber der des ersten Eingangssignals größer oder kleiner sein. Beim Auftreten einer vorgegebenen Flanke des ersten Eingangssignals und beim Auftreten von weiteren x ≥ 1 vorgegebenen Flanken des ersten Eingangssignals vor einer nächsten vorgegebenen Flanke des zweiten Eingangssignals werden x zweite Schaltsignale dem Vorwärts/Rückwärts-Zähler als Zählsignal zugeführt, die den Zähler vorwärtszählen. Beim Auftreten dagegen einer vorgegebenen Flanke des ersten Eingangssignals und beim Auftreten von y ≥ 2 vorgegebenen Flanken des zweiten Eingangssignals vor der nächsten vorgegebenen Flanke des ersten Eingangssignals werden y - 1 Schaltsignale dem Vorwärts/Rückwärts-Zähler als Zählsignal zugeführt, die in Rückwärtszählen.

Die Frequenz des ersten Eingangssignals kann somit erheblich von der Frequenz des zweiten Eingangssignals abweichen. Die Auflösung der Phasenmessung kann mit der Festlegung der Frequenz des Taktsignals auf ein vorgegebenes Vielfaches der Frequenz des ersten Eingangssignals vorgegeben werden. Wesentlich ist hierbei, daß die Frequenz des Taktsignals ein ganzzahliges Vielfaches der Frequenz des ersten Eingangssignals ist.

Vorteilhafte Weiterbildungen und Ausgestaltungen der erfindungsgemäßen Phasenmeßvorrichtung ergeben sich aus abhängigen Ansprüchen.

Eine vorteilhafte Ausgestaltung sieht vor, daß die Taktfrequenz ein Vielfaches einer Zweierpotenz des ersten Eingangssignals beträgt. Die Auswahl einer Zweierpotenz ermöglicht eine einfache schaltungstechnische Realisierung mit einem Binärzähler.

Die erfindungsgemäße Phasenmeßvorrichtung ist sowohl für analoge als auch für digitale Eingangssignale geeignet. Analoge Eingangssignale können jeweils einem Komparator zugeleitet werden, der ein digitales Signal abgibt.

Die erfindungsgemäße Phasenmeßvorrichtung ist besonders geeignet zur Auswertung von Phasendifferenzen von Signalen, die von Photodetektoren abgegeben werden, die in Heterodyninterferometern eingesetzt sind. Bei dieser Anwendung ist eine hohe Meßrate erforderlich, wenn eine Information über die Bewegung eines Meßobjekts erhalten werden soll. Das erste Eingangssignal ist vorzugsweise das Referenzsignal, das eine bekannte, fest vorgegebene Frequenz aufweist. Das zweite Eingangssignal ist das vom Meßobjekt beeinflußte Meßsignal, das während einer Bewegung des Meßobjekts eine variable Frequenz aufweist. Die Ermittlung von Phasendifferenzen in einem Meßbereich von beliebigen Vielfachen von 360° ermöglicht die Bestimmung der Bewegung des Meßobjekts in einem entsprechend großen Ortsbereich.

Weitere vorteilhafte Weiterbildungen und Ausgestaltungen der erfindungsgemäßen Phasenmeßvorrichtung ergeben sich aus weiteren Unteransprüchen in Verbindung mit der folgenden Beschreibung.

### Zeichnung

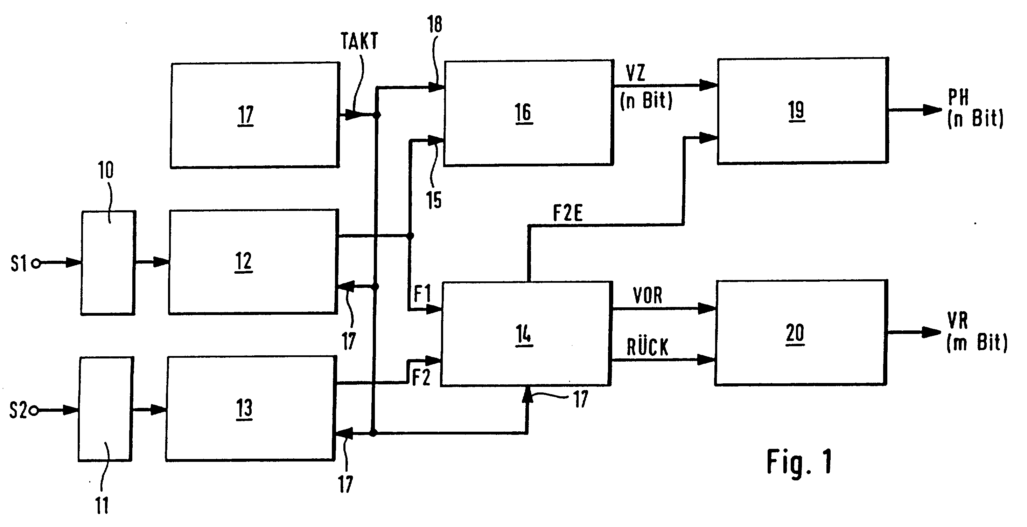

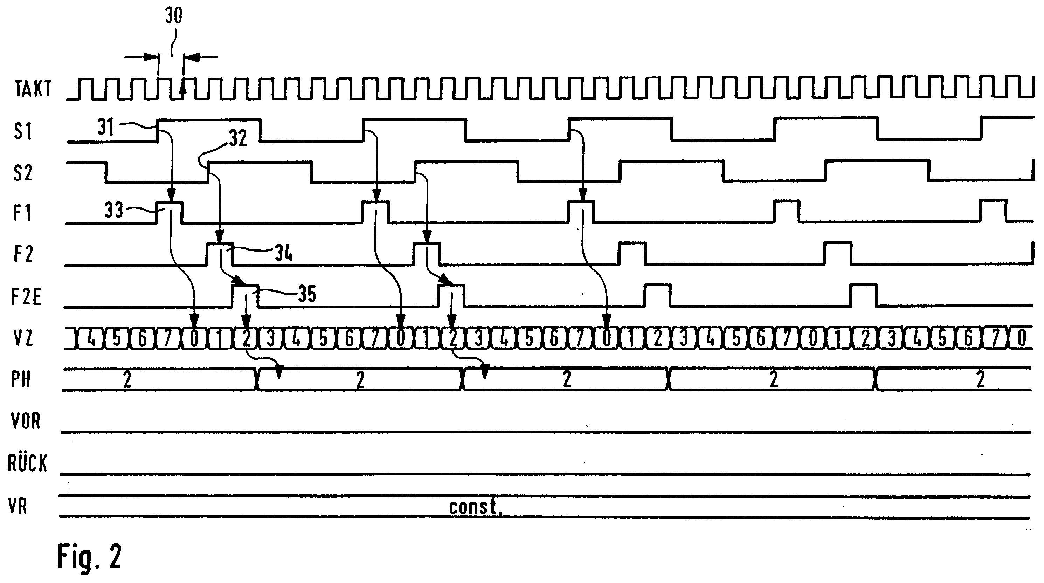

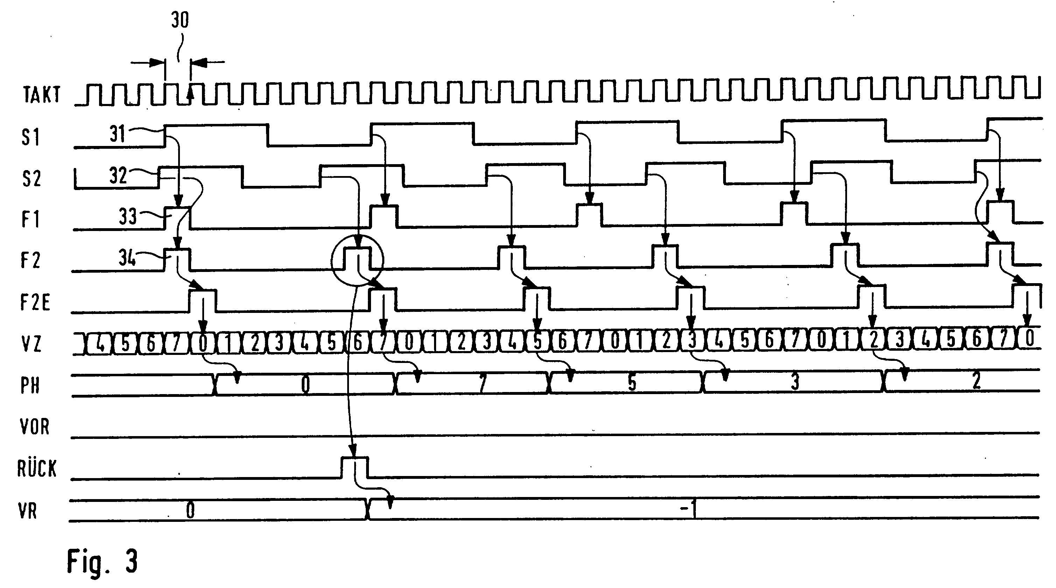

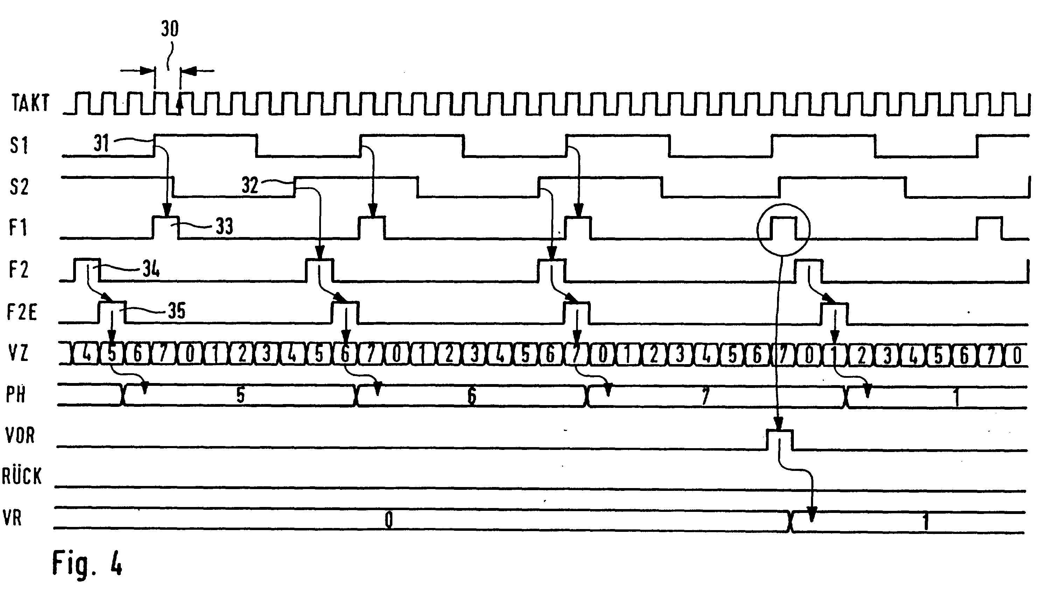

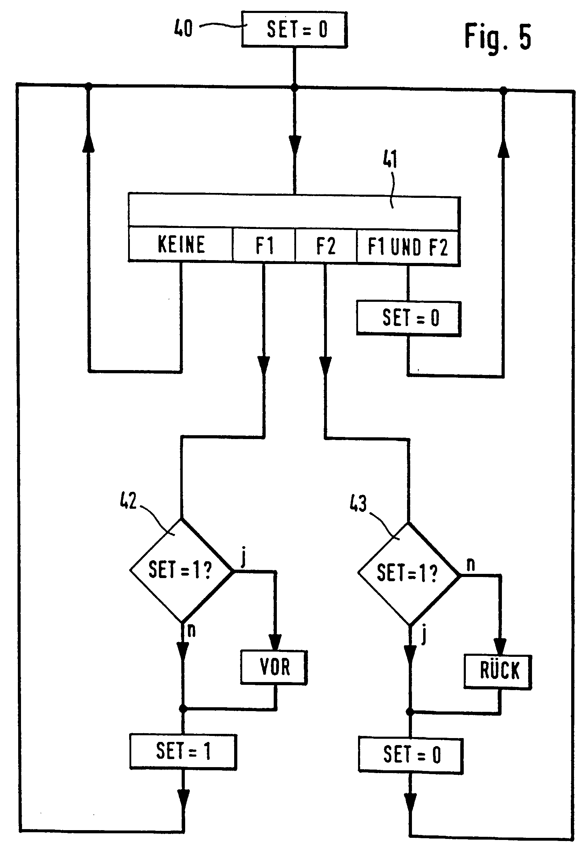

Figur 1 zeigt ein Blockschaltbild einer erfindungsgemäßen Phasenmeßvorrichtung, Figuren 2-4 zeigen Impulse in Abhängigkeit von der Zeit, die in der Vorrichtung gemäß Figur 1 auftreten, wobei in Figur 2 die Frequenzen von zwei Eingangssignalen gleich sind, in Figur 3 die Frequenz des zweiten Eingangssignals größer als die des ersten Eingangssignals und in Figur 4 die Frequenz des zweiten Eingangssignals kleiner als die des ersten Eingangssignals ist, und Figur 5 zeigt ein Flußdiagramm eines Verfahrensablaufs, der in der erfindungsgemäßen Phasenmeßvorrichtung auftritt.

In Figur 1 ist ein erstes Eingangssignal S1 einem ersten Komparator 10 und ein zweites Eingangssignal S2 einem zweiten Komparator 11 zugeführt. Der erste Komparator 10 gibt ein Signal an einen ersten Flankendetektor 12 weiter und der zweite Komparator 11 leitet ein Signal einem zweiten Flankendetektor 13 zu. Der erste Flankendetektor 12 gibt ein erstes Signal F1 an eine Steuerschaltung 14 ab. Das erste Signal F1 ist gleichzeitig ein Rücksetzsignal 15 für einen ersten Zähler 16. Der zweite Flankendetektor 13 gibt ein zweites Signal F2 an die Steuerschaltung 14 ab. Vorgesehen ist ein Taktgenerator 17, der ein Taktsignal TAKT an den ersten und zweiten Flankendetektor 12, 13 sowie an die Steuerschaltung 14 abgibt. Das Taktsignal TAKT ist weiterhin als erstes Zählsignal 18 dem ersten Zähler 16 zugeführt. Der erste Zähler 16 gibt ein digitales n Bit breites Ausgangssignal VZ, das den Zählerstand repräsentiert, an ein Register 19 ab, dem weiterhin ein Steuersignal F2E zugeleitet ist, das die Steuerschaltung 14 abgibt. Das Register 19 stellt eine digitale n Bit breite erste Zahl PH am Ausgang zur Verfügung. Die Steuerschaltung 14 gibt weiterhin ein erstes Schaltsignal VOR und ein zweites Schaltsignal RÜCK an einen m Bit breiten Zähler 20 ab, der an seinem Ausgang eine digitale m Bit breite zweite Zahl VR zur Verfügung stellt.

Die Arbeitsweise der in Figur 1 gezeigten Phasenmeßvorrichtung wird anhand der in den Figuren 2-4 gezeigten Signalverläufe näher erläutert:

In den Figuren 2-4 ist angenommen, daß die Eingangssignale S1, S2 in digitaler Form vorliegen. Sofern die Eingangssignale S1, S2 nicht digitale Signale sind, können die Komparatoren 10, 11 vorgesehen sein, die analoge Eingangssignale S1, S2 in entsprechende digitale Signale umformen.

In den Figuren 2-4 sind Pfeile eingetragen, die Einweise darauf geben, welche Signale sich ändern in Abhängigkeit von Pegeln oder aufgetretenen Flanken in anderen Signalen.

Die beiden Eingangssignale S1, S2 weisen prinzipiell keinen zeitlichen Bezug zu dem Taktsignal TAKT auf. Die beiden Flankendetektoren 12, 13 stellen diesen zeitlichen Bezug her, um eine einfache taktsignalbezogene synchrone Signalverarbeitung vornehmen zu können. Die beiden Flankendetektoren 12, 13 sind vom Taktsignal TAKT gesteuerte Flankendetektoren, die jeweils nach einer vorgegebenen Flanke 31, 32 der Eingangssignale S1, S2 einen Impuls 33, 34 mit der Dauer einer Taktperiode 30 als erstes und als zweites Signal F1, F2 abgeben. In den Figuren 2-4 ist unterstellt, daß die vorgegebenen Flanken 31, 32 jeweils die positiven Flanken sind. Das erste Signal F1 zeigt daher für die Dauer einer Taktperiode 30 an, daß eine positive Signalflanke 31 des ersten Signals S1 aufgetreten ist während entsprechend das zweite Signal F2 das Auftreten einer positiven Flanke 32 des zweiten Eingangsignals S2 für die Dauer einer Taktperiode 30 signalisiert.

Ein erster Teil der erfindungsgemäßen Vorrichtung dient der Ermittlung einer Phasendifferenz zwischen den beiden Eingangssignalen S1, S2, die bis zu 360° betragen kann.

Die Frequenz des Taktsignals TAKT soll ein Vielfaches der Frequenz des ersten Eingangssignals S1 betragen. Das Eingangssignal S1 soll das Bezugssignal sein, gegenüber dem die Phasenverschiebung des zweiten Eingangssignals S2 ermittelt wird. In der Praxis ist häufig die Frequenz des ersten Eingangssignals S1 bekannt. Wie bereits erwähnt, liegt aber kein Phasenbezug zum Taktsignal TAKT vor. Im folgenden wird vorausgesetzt, daß als Vielfaches eine Zweierpotenz gewählt wird. Der Vorteil liegt darin, daß als erster Zähler 16 ein Binärzähler mit einer Breite von n Bit Verwendung finden kann.

Der erste Zähler 16 ist beispielsweise ein synchroner n Bit breiter Vorwärtszähler, der jeweils bei einer positiven Flanke des mit dem Taktsignal TAKT identischen ersten Zählsignals 18 inkrementiert wird. Der Zähler weist die Besonderheit auf, daß er bei Erreichen des Zählerstandes (2ⁿ-1) auch bei Auftreten von weiteren Taktsignalen TAKT auf dem Zählerstand (2ⁿ-1) stehen bleibt (und nicht auf die Zählerstände 0, 1, 2 ... weiterspringt.

Der momentane Zählerstand wird durch das n Bit breite Ausgangssignal VZ des ersten Zählers 16 repräsentiert. Jede positive Signalflanke 31 des ersten Eingangssignals S1, die durch Impulse 33 des ersten Signals F1 angezeigt wird, lösen ein Rücksetzen des 1. Zählers 16 auf einen vorbestimmten Wert, vorzugsweise den Wert Null, aus. Das Rücksetzsignal 15 ist identisch mit dem ersten Signal F1. Als aktive Flanken des ersten Signals F1, die den Rücksetzvorgang bewirken, sind in den Figuren 2-4 die fallenden Flanken der Impulse 33 vorgesehen, die synchron mit aer nächsten aktiven (positiven) Flanke des Taktsignals TAKT auftreten. Die aktive Taktsignalflanke ist jeweils mit einem Pfeil gekennzeichnet.

Das Steuersignal F2E zeigt an, wann das n Bit breite Ausgangssignal VZ des ersten Zählers 16 gültig ist. Das Steuersignal F2E wird in der Steuerschaltung 14 auf einfachste Weise aus dem zweiten Signal F2 im Anschluß an die fallende Flanken der Impulse 34 taktsynchron erzeugt. Das Steuersignal F2E ist von Impulsen 35 gebildet, die beispielsweise die Dauer 30 einer Taktperiode aufweisen. Während der Dauer der Impulse 35 ist das Ausgangssignal VZ gültig. Die negative Flanke der Impulse 35 veranlaßt die Übernahme des Ausgangssignals VZ in das Register 19, das den Stand des 1. Zählers 16 speichert bis zum nächsten Auftreten des nächsten Impulses des Steuersignais F2E.

Am Ausgang des Registers 19 steht die n Bit breite erste Zahl PH zur Verfügung, die als positive Integerzahl interpretiert werden kann. Die erste Zahl PH repräsentiert die momentane Phasenverschiebung zwischen den beiden Eingangssignalen S1, S2, die zwischen Null Grad und 360° liegen kann. Die Auflösung beträgt 360°/(2ⁿ), wobei in den Figuren 2-4 angenommen ist, daß 2ⁿ den Wert 8 aufweist. Somit ist die Frequenz des Taktsignals TAKT achtmal höher als die Frequenz des ersten Eingangssignals S1.

In Figur 2 ist der Fall gezeigt, bei dem die Frequenzen der beiden Eingangssignale S1, S2 gleich sind. Die (konstante) Phasendifferenz ist mit dem Wert 2 der ersten Zahl PH angenommen, der einem Winkel von 90° zugeordnet ist.

In den Figuren 3 und 4 sind die Fälle dargestellt, bei denen die Frequenzen der beiden Eingangssignale S1, S2 unterschiedlich sind. In Figur 3 ist die Frequenz des zweiten Eingangssigtnals S2 höher als die des ersten Eingangssignals S1 und Figur 4 zeigt den umgekehrten Fall. Die Phasendifferenz ändert sich ständig. Besonders wesentlich ist es, daß aktuelle Werte der Phasenverschiebung nach jeder vorgegebenen Flanke 32 des zweiten Eingangssignals S2 vorliegen.

Mit anderen Teilen der erfindungsgemäßen Phasenmeßvorrichtung, die mit dem ersten Teil kombiniert werden, sind eindeutige Phasenmessungen um Vielfache von 360° Phasendifferenz möglich. Die beiden anderen Teile enthalten im wesentlichen den zweiten Zähler 20, dem ein erstes Schaltsignal VOR oder ein zweites Schaltsignal RÜCK als zweites oder drittes Zählsignal zugeführt sind. Das erste und zweite Schaltsignal VOR, RÜCK erzeugt die Steuerschaltung 14 in Abhängigkeit vom ersten und zweiten Signal F1, F2. Der zweite Teil der erfindungsgemäßen Phasenmeßvorrichtung unterscheidet sich vom dritten Teil dadurch, daß beim zweiten Teil die Frequenz des zweiten Eingangssignals S2 höher als die des ersten Eingangssignals S1 ist, während beim dritten Teil die Verhältnisse umgekehrt sind. Der zweite und dritte Teil sind dadurch kombiniert, daß der zweite Zähler 20 als Vorwärts-Rückwärtszähler ausgebildet ist, wobei das erste Schaltsignal VOR dem zweiten Zähler als zweites Zählsignal und das dritte Schaltsignal RÜCK dem zweiten Zähler 20 als zweites Zählsignal zugeleitet sind.

Die Bereitstellung des ersten und zweiten Schaltsignals VOR, RÜCK durch die Steuerschaltung 14 wird anhand des in Figur 5 gezeigten Flußdiagramms näher erläutert:

Das Verfahren beginnt mit einer Initialisierung 40, bei der eine Hilfsgröße, die mit SET bezeichnet ist, gleich Null gesetzt wird. Die Hilfsgröße SET ist beispielsweise ein Speicherinhalt, der beim Auftreten von vorgegebenen Flanken 31, 32 der Eingangssignale S1, S2 oder - gemäß den in den Figuren 2-4 gezeigten Beispielen mit taktsignalsynchroner Signalverarbeitung - beim Auftreten von Impulsen 33, 34 des ersten und/oder zweiten Signals F1, F2 geändert wird. Nach der Initialisierung 40 folgt ein Flankentest 41. Tritt der triviale Fall auf, daß kein Impuls 33, 34, entsprechend einer Flanke 31, 32 festgestellt wurde, so wird der Flankentest 41 erneut durchgeführt. Wird im Flankentest 41 das Auftreten des Impulses 33 des ersten Signals F1, entsprechend der vorgegebenen Flanke 31 des ersten Eingangssignals S1 festgestellt, dann wird in einer ersten Abfrage 42 nachgesehen, ob die Hilfsgröße SET = 1 ist. Falls dies nicht der Fall ist, wird der Hilfsgröße SET der Wert 1 zugewiesen und danach wieder der Flankentest 41 durchgeführt. Wird dagegen in der ersten Abfrage 42 festgestellt, daß die Hilfsgröße SET = 1 ist, so wird das zweite Schaltsignal VOR von der Steuerschaltung 14 erzeugt, das als drittes Zählsignal dem zweiten Zähler 20 zugeführt ist.

Das Auftreten des zweiten Schaltsignals VOR entspricht dem in Figur 4 gezeigten Fall, bei dem die Frequenz des ersten Eingangssignals S1 höher ist als die Frequenz des zweiten Eingangssignal S2. Die m Bit breite zweite Zahl VR am Ausgang des zweiten Zählers 20 wird dabei um 1 erhöht. Die Erhöhung um 1 bedeutet, daß eine Phasenvoreilung um 360° des ersten Eingangssignals S1 gegenüber dem zweiten Eingangssignal S2 aufgetreten ist.

Wird im Flankentest 41 das Auftreten des Impulses 34 des zweiten Signals F2, entsprechend der vorgegebenen Flanke 32 des zweiten Eingangssignals S2 festgestellt, dann wird in einer zweiten Abfrage 43 nachgesehen, ob die Hilfsgröße SET den Wert 1 aufweist. Falls dies zutrifft, wird anschließend die Hilfsgröße SET auf Null gesetzt und anschließend wieder der Flankentest 41 durchgeführt. Wird in der zweiten Abfrage 43 festgestellt, daß die Hilfsgröße SET den Wert Null aufweist, dann erzeugt die Steuerschaltung 14 das erste Schaltsignal RÜCK, das dem zweiten Zähler 20 als zweites Zählsignal zugeführt ist. Dieser Fall ist in Figur 3 gezeigt, bei dem die Frequenz des ersten Eingangssignals S1 niedriger ist als die Frequenz des zweiten Eingangssignals S2. Die m Bit breite zweite Zahl VR am Ausgang des zweiten Zählers 20 wird durch das zweite Zählsignal RÜCK um 1 vermindert. Die Verminderung um 1 bedeutet eine Phasennacheilung um 360° des ersten Eingangssignals S1 gegenüber dem zweiten Eingangssignal S2.

Bei der Durchführung des Flankentests 41 kann der Fall auftreten, daß die Impulse 33, 34 der beiden Signale F1, F2 gleichzeitig auftreten. Sofern anstelle der beiden Signale F1, F2 die beiden digitalen Eingangssignale S1, S2 unmittelbar auf das Auftreten von vorgegebenen Flanken 31, 32 hin untersucht werden, tritt dieser Fall selten auf. Hier würde das gleichzeitige Auftreten der vorgegebenen Signalflanken 31, 32 abhängen von der anschließenden Signalverarbeitung, die nur eine begrenzte Arbeitsgeschwindigkeit aufweist. Unter Heranziehung der mit dem Taktsignal TAKT synchronisierten beiden Signalen F1, F2 tritt dieser Spezialfall häufiger auf. Die Wahrscheinlichkeit für das Auftreten hängt dann davon ab, um wieviel ganzzahlige Vielfache die Frequenz des Taktsignals TAKT höher ist als die Frequenz des ersten Eingangssignals F1. Bei den in den Figuren 2-4 gezeigten Fällen, bei denen 2ⁿ den Wert 8 aufweist, beträgt die Wahrscheinlichkeit für das gleichzeitige Auftreten der beiden Signale F1, F2 1/8. Dieser Spezialfall ist in Figur 2 gezeigt. Es wird weder ein zweites noch ein drittes Schaltsignal VOR, RÜCK von der Steuerschaltung 14 erzeugt. Nachdem dieser Sachverhalt im Flankentest 41 festgestellt wurde, wird erneut ein Flankentest 41 durchgeführt, wobei zuvor die Hilfsgröße SET auf Null gesetzt wird. Der zweite Zähler 20 behält seinen erreichten Zählerstand unverändert bei.

Wie beim ersten Teil ist es auch bei den anderen Teilen der erfindungsgemäßen Phasenmeßvorrichtung besonders vorteilhaft, daß sofort bei einer Überschreitung einer Phasendifferenz von 360° ein aktueller Wert vorliegt.

Durch Zusammenfassung der m Bit breiten zweiten Zahl VZ mit der n Bit breiten ersten Zahl PH erhält man eine einzige (m+n) Bit breite Zahl VZ.PH, die den Phasenmeßwert vollständig repräsentiert. Wenn das Verhältnis der Frequenzen des Taktsignals TAKT und des ersten Eingangssignals S1 eine Zweierpotenz ist, kann die (m+n) Bit breite Zahl VZ.PH direkt als Zweierkomplementzahl mit m Vorkommastellen und n Nachkommastellen interpretiert werden, die den Phasenunterscheid in Einheiten von 360 Grad repräsentiert.

Zur Erhöhung der Meßgenauigkeit bei eventuell reduzierter Meßrate können mehrere Phasenmeßwerte VZ.PH aufaddiert und anschließend durch die Anzahl der Meßwerte dividiert werden.

Vorzugsweise ist die Anzahl der zu mittelnden Phasenmeßwerte eine Zweierpotenz. Die Division durch diese Zweierpotenz läßt sich dann durch eine einfach Rechtsverschiebung um die entsprechende Stellenzahl eines Binärworts, welches das Mittelungsergebnis darstellt, bewerkstelligen.

## Patentansprüche

1. Vorrichtung zum Ermitteln der Phasendifferenz zwischen einem ersten und zweiten digitalen Eingangssignal mit den Merkmalen:
- ein Taktgenerator (17) gibt ein Taktsignal (TAKT) ab, dessen Frequenz ein ganzzahliges Vielfaches der Frequenz des ersten Eingangssignals (S1) ist,
- das Taktsignal (TAKT) ist einem ersten Zähler (16) als erstes Zählsignal (18) zugeführt,
- jede vorgegebene Flanke (31) des ersten Eingangssignals (S1) setzt den ersten Zähler (16) zurück,
- beim Auftreten jeder vorgegebenen Flanke (32) des zweiten Eingangssignals (S2) wird der Zählerstand des ersten Zählers (16) als ein Maß für die Phasendifferenz im Bereich von 0 bis 360° gewertet,
- beim Auftreten einer vorgegebenen Flanke (31) des ersten Eingangssignals (S1) und beim Auftreten von weiteren x ≥ 1 vorgegebenen Flanken (31) des ersten Eingangssignals (S1) vor einer nächsten vorgegebenen Flanke (32) des zweiten Eingangssignals (S2) werden x zweite Schaltsignale (VOR) einem Vorwärts/Rückwärts-Zähler (20) als zweites Zählsignal zugeführt,
- das den Vorwärts/Rückwärts-Zähler (20) vorwärts zählt,
- beim Auftreten einer vorgegebenen Flanke (31) des ersten Eingangssignals (S1) und beim Auftreten von y ≥ 2 vorgegebenen Flanken (32) des zweiten Eingangssignals (S2) vor der nächsten vorgegebenen Flanke (31) des ersten Eingangssignals (S1) werden y - 1 dritte Schaltsignale (RÜCK) dem Vorwärts/Rückwärts-Zähler (20) als drittes Zählsignal zugeführt, das den Vorwärts/Rückwärts-Zähler (20) rückwärts zählt und
- der Zählerstand des Vorwärts/Rückwärts-Zählers (20) wird als Maß für Vielfache von 360° Phasendifferenz gewertet.

2. Vorrichtung nach Anspruch 1, dadurch gekennzeichnet, daß die Frequenz des Taktsignals (TAKT) auf ein Vielfaches einer Zweierpotenz der Frequenz des ersten Eingangssignals (S1) festgelegt ist.

3. Vorrichtung nach Anspruch 1, dadurch gekennzeichnet, daß die Eingangssignale (S1, S2) Komparatoren (10, 11) zugeführt sind, die die Eingangssignale (S1, S2) in entsprechende digitale Signale umformen.

4. Vorrichtung nach Anspruch 1, dadurch gekennzeichnet, daß das Ergebnis einer Mittelwertbildung unterworfen ist.

5. Vorrichtung nach Anspruch 1, dadurch gekennzeichnet, daß der erste Zähler (16) als n Bit breiter Vorwärtszähler realisiert ist.

6. Vorrichtung nach Anspruch 5, dadurch gekennzeichnet, daß der erste Zähler (16) bei Erreichen des vorgegebenen Zählerstands 2ⁿ-1 auch bei Auftreten von weiteren Taktsignalen (TAKT) auf dem Zählerstand 2ⁿ-1 stehenbleibt.

7. Verwendung der Vorrichtung nach Anspruch 1 bei einem Heterodyninterferometer, wobei die beiden Eingangssignale (S1, S2) die Ausgangssignale von zwei Photodetektoren sind.

## Claims

1. Device for determining the phase difference between a first and a second digital input signal, having the features:
- a clock generator (17) outputs a clock signal (CLOCK) whose frequency is an integer multiple of the frequency of the first input signal (S1),
- the clock signal (CLOCK) is supplied to a first counter (16) as a first counting signal (18),
- each predetermined flank (31) of the first input signal (S1) resets the first counter (16),
- whenever each predetermined flank (32) of the second input signal (S2) occurs, the count of the first counter (16) is evaluated as a measure of the phase difference in the range from 0 to 360°,
- whenever a predetermined flank (31) of the first input signal (S1) occurs and whenever a further x ≥ 1 predetermined flanks (31) of the first input signal (S1) occur before a next predetermined flank (32) of the second input signal (S2), x second switching signals (UP) are supplied to an up/down counter (20) as a second counting signal,
- which counts the up/down counter (20) upwards,
- whenever a predetermined flank (31) of the first input signal (S1) occurs and whenever y ≥ 2 predetermined flanks (32) of the second input signal (S2) occur before the next predetermined flank (31) of the first input signal (S1), y - 1 third switching signals (down) are supplied to the up/down counter (20) as a third counting signal which counts the up/down counter (20) downwards, and
- the count of the up/down counter (20) is evaluated as a measure of multiples of 360° phase difference.

2. Device according to Claim 1, characterized in that the frequency of the clock signal (CLOCK) is set to a multiple of a power of two of the frequency of the first input signal (S1).

3. Device according to Claim 1, characterized in that the input signals (S1, S2) are supplied to comparators (10, 11) which convert the input signals (S1, S2) into corresponding digital signals.

4. Device according to Claim 1, characterized in that the result is subjected to averaging.

5. Device according to Claim 1, characterized in that the first counter (16) is designed as an n-bit long up counter.

6. Device according to Claim 5, characterized in that, on reaching the predetermined count 2ⁿ-1, the first counter (16) remains at the count 2ⁿ-1 even if further clock signals (CLOCK) occur.

7. Use of the device according to Claim 1 in a heterodyne interferometer, the two input signals (S1, S2) being the output signals from two photodetectors.

## Revendications

1. Dispositif pour déterminer la différence de phase entre un premier et un second signal numérique d'entrée ayant les caractéristiques suivantes :
• un générateur d'horloge (17) fournissant un signal d'horloge (HOR) dont la fréquence est un multiple entier de la fréquence du premier signal d'entrée (S1),
• le signal de cadence (HOR) est appliqué à un premier compteur (16) comme premier signal de comptage (18),
• chaque flanc prédéterminé (31) du premier signal d'entrée (S1) remet le premier compteur (16),
• à l'arrivée de chaque flanc prédéterminé (32) du second signal d'entrée (S2), l'état de comptage du premier compteur (16) est exploité comme une mesure de la différence de phase dans la plage comprise entre 0° et 360°,
• à l'arrivée d'un flanc prédéterminé (31) du premier signal d'entrée (S1) et à l'arrivée des autres x ≥ 1 flanc prédéterminé (31) du premier signal d'entrée (S1) avant le flanc suivant prédéterminé (32) du second signal d'entrée (S2), un compteur/décompteur (20) reçoit comme second signal d'entrée (x) seconds signaux de commutation (AV),
• ce signal faisant compter le compteur/décompteur (20),
• à l'arrivée d'un flanc prédéterminé (31) du premier signal d'entrée (S1) et à l'arrivée de y ≥ 2 flancs prédéterminés (32) du second signal d'entrée (S2) avant le flanc prédéterminé suivant (31) du premier signal d'entrée (S1), le compteur/décompteur (20) reçoit comme troisième signal de comptage (y - 1) les troisièmes signaux de commutation (RUCK) qui font décompter le compteur/décompteur (20) et
• l'état de comptage du compteur/décompteur (20) est exploité comme mesure du multiple d'une différence de phase de 360°.

2. Dispositif selon la revendication 1,
caractérisé en ce que
la fréquence du signal d'horloge (HOR) est fixée à un multiple d'une puissance de deux de la fréquence du premier signal d'entrée (S1).

3. Dispositif selon la revendication 2,
caractérisé en ce que
les signaux d'entrée (S1, S2) sont appliqués à des comparateurs (10, 11) qui transforment les signaux d'entrée (S1, S2) en des signaux numériques correspondants.

4. Dispositif selon la revendication 1,
caractérisé en ce que
le résultat est soumis à la formation d'une valeur moyenne.

5. Dispositif selon la revendication 1,
caractérisé en ce que
le premier compteur (16) est réalisé sous la forme d'un compteur d'une largeur de (n) bits.

6. Dispositif selon la revendication 5,
caractérisé en ce que
le premier compteur (16), lorsqu'on atteint l'état de comptage prédéterminé de la puissance (2ⁿ-1), reste fixé sur l'état de comptage (2ⁿ-1) même si d'autres signaux de cadence (HOR) apparaissent.

7. Application du dispositif selon la revendication 1 à un interféromètre hétérodyne dont les deux signaux d'entrée (S1, S2) sont les signaux de sortie de deux photodétecteurs.
